# EUROPEAN PATENT APPLICATION

(11) **EP 4 621 836 A1**
(43) Date of publication of application: **24.09.2025**
(21) Application number: 22965892.7
(22) Date of filing: 18.11.2022
(51) Int. Cl.: H01L 21/683

(54) **TRANSFER SUBSTRATE**

(71) Applicant: LG Electronics Inc., Yeongdeungpo-gu Seoul 07336 (KR); LG Display Co., Ltd., Seoul, 07336 (KR)
(72) Inventor: KIM, Yoonchul, Seoul 06772 (KR); MOON, Sunghyun, Seoul 06772 (KR); KIM, Jungsub, Seoul 06772 (KR)
(74) Representative: Vossius & Partner Patentanwälte Rechtsanwälte mbB
(86) International application number: PCT/KR2022/018266
(87) International publication number: WO 2024/106572

(57) **Abstract**

The transfer substrate may include a first layer and a second layer on the first layer. The second layer may have an amount of a curing agent smaller than an amount of a curing agent of the first layer. The second layer may have tackiness greater than a tackiness of the first layer, and the second layer may have a hardness the smaller than a hardness of the first layer.

## Description

### [Technical Field]

The embodiment relates to a transfer substrate for transferring a semiconductor light-emitting element.

### [Background Art]

A large-area display includes a liquid crystal display (LCD), an OLED display, and a micro-LED display.

A micro-LED display is a display that uses micro-LEDs, which are semiconductor light-emitting elements as a display elements, each having a diameter or cross-sectional area of 100µm or less.

Since the micro-LED display uses the micro-LEDs, which are the semiconductor light-emitting elements as the display elements, it has excellent performance in many characteristics such as contrast ratio, response speed, color reproducibility, viewing angle, brightness, resolution, lifespan, luminous efficiency, or luminance.

In particular, the micro-LED display has the advantage of being able to freely adjust the size or resolution by separating and combining the screen in a modular manner, and the advantage of being able to implement a flexible display.

However, since a large micro-LED display requires millions or more micro-LEDs, there is a technical problem that makes it difficult to quickly and accurately transfer the micro-LEDs to a display panel.

Recently developed transfer technologies include the pick and place process, the laser lift-off method, or the self-assembly method.

Among these, the pick and place process is a method of picking up a plurality of semiconductor light-emitting elements using a transfer substrate and transferring them onto a backplane substrate.

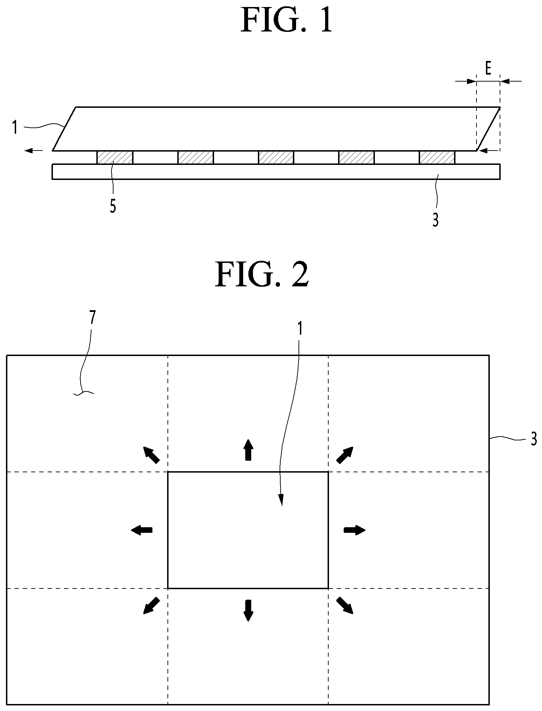

As illustrated in FIG. 1, the plurality of semiconductor light-emitting elements 5 on a wafer are picked up by the transfer substrate 1 and moved to the backplane substrate 3, and then the plurality of semiconductor light-emitting elements 5 are transferred from the transfer substrate 1 to the backplane substrate 3.

Since it is difficult to enlarge the transfer substrate 1, the transfer process is repeatedly performed tens to hundreds of times, so that the semiconductor light-emitting elements 5 are transferred onto a display region of the backplane substrate 3.

In this way, the transfer process is repeatedly performed tens to hundreds of times for each backplane substrate 3, causing the transfer substrate 1 to undergo deformation, i.e., stretching. Here, deformation means that it is twisted from a preset reference point. In this instance, arrangement errors E occurs in the plurality of semiconductor light-emitting elements 5 picked up on the transfer substrate 1, which leads to an alignment error. When an alignment error occurs, each of the plurality of semiconductor light-emitting elements 5 transferred by the transfer substrate 1 is positioned in a region other than a desired region (pixel). For example, each of the plurality of semiconductor light-emitting elements 5 is positioned between adjacent pixels, not in its own pixel.

In this way, when the electrical connection process is performed by the post-process while the alignment error occurs in the plurality of semiconductor light-emitting elements 5, there is a problem that the electrode wiring is not electrically connected to each of the plurality of semiconductor light-emitting elements, resulting in a disconnection defect, which leads to a lighting failure.

Meanwhile, as illustrated in FIG. 2, the transfer substrate 1 is repeatedly transferred multiple times, so that the plurality of semiconductor light-emitting elements 5 are transferred onto a plurality of block regions 7 of the backplane substrate 3. The block region 7 refers to a region where the plurality of semiconductor light-emitting elements 5 are transferred by one transfer process of the transfer substrate 1. That is, when the backplane substrate 3 is divided into nine block regions 7, the plurality of semiconductor light-emitting elements 5 are transferred onto the nine block regions 7 provided on the backplane substrate 3 through nine transfer processes. In FIG. 2, nine block regions 7 are illustrated for convenience of explanation, but the number of block regions 7 varies depending on the size of the backplane substrate 3 or the size of the transfer substrate 1.

The transfer substrate 1 is pressed, and a plurality of semiconductor light-emitting elements 5 on the transfer substrate 1 are transferred onto the backplane substrate 3. When the transfer substrate 1 is pressed, stress is transferred from the center of the transfer substrate 1 to the edge, and the stress transferred to the edge of the transfer substrate 1 is transferred to the peripheral block region that is in contact with the block region currently being transferred through the plurality of semiconductor light-emitting elements 5. When the backplane substrate 3 has a thin thickness or a flexible characteristic, it is deformed and warped or bent by the stress transferred from the transfer substrate 1. In this instance, when a plurality of semiconductor light-emitting elements 5 have already been transferred among the peripheral block regions, the plurality of semiconductor light-emitting elements 5 are also warped or bent, which causes a problem of poor lighting due to electrical disconnection during the post-process. In addition, when the plurality of semiconductor light-emitting elements 5 are also warped or bent, there is a problem that the already transferred semiconductor light-emitting elements are detached from the backplane substrate 3.

### [Disclosure]

### [Technical Problem]

An object of the embodiment is to solve the foregoing and other problems.

Another object of the embodiment is to provide a transfer substrate capable of preventing alignment errors.

Another object of the embodiment is to provide a transfer substrate capable of improving yield.

In addition, another object of the embodiment is to provide a transfer substrate capable of preventing stress.

The technical problems of the embodiments are not limited to those described in this item and comprise those that may be understood through the description of the invention.

### [Technical Solution]

According to one aspect of the embodiment, in order to achieve the above or other objects, a transfer substrate, comprising: a first layer; and a second layer on the first layer, wherein the second layer has an amount of a curing agent smaller than an amount of a curing agent of the first layer, wherein the second layer has a tackiness greater than a tackiness of the first layer, and wherein the second layer has a hardness smaller than a hardness of the first layer.

The amount of the curing agent of the first layer may be 11 wt% to 13 wt%, and the amount of the curing agent of the second layer may be 9 wt% to 10 wt%.

The second layer may comprise a plurality of protrusions; and a recess around each of the plurality of protrusions.

The plurality of protrusions may each have a size corresponding to a size of at least one pixel, and the pixel may comprise a plurality of subpixels corresponding to a plurality of semiconductor light-emitting elements, respectively.

The transfer substrate may comprise a third layer in the recess.

The first layer to the third layer may comprise the same organic material, and the third layer may have an amount of the curing agent equal to or smaller than the amount of the curing agent of the first layer and greater than the amount of a curing agent of the protrusion.

The third layer may have a tackiness equal to or greater than the tackiness of the first layer and smaller than a tackiness of the second layer,
wherein the third layer may have a hardness equal to or smaller than the hardness of the first layer and greater than a hardness of the second layer.

The transfer substrate of claim 5, wherein the third layer is an extension part extending from the first layer.

The transfer substrate of claim 5, wherein the third layer may have a thickness smaller than a thickness of the protrusion.

The transfer substrate may comprise a support member under the first layer, and the support member and the first layer may comprise different organic materials.

The support member may comprise a plastic material, and the first layer and the second layer may comprise silicon materials.

The transfer substrate may comprise a fourth layer under the first layer, and the first layer, the second layer, and the fourth layer may comprise the same organic material, and the fourth layer may have an amount of a curing agent greater than the amount of the curing agent of the first layer.

The amount of the curing agent of the fourth layer may be at least twice greater than the amount of the curing agent of the second layer.

The first layer may have an area greater than an area of the second layer, and the transfer substrate may comprise a second recess along a perimeter of an outer side of the second layer in an edge region of an upper surface of the first layer.

### [Advantageous Effects]

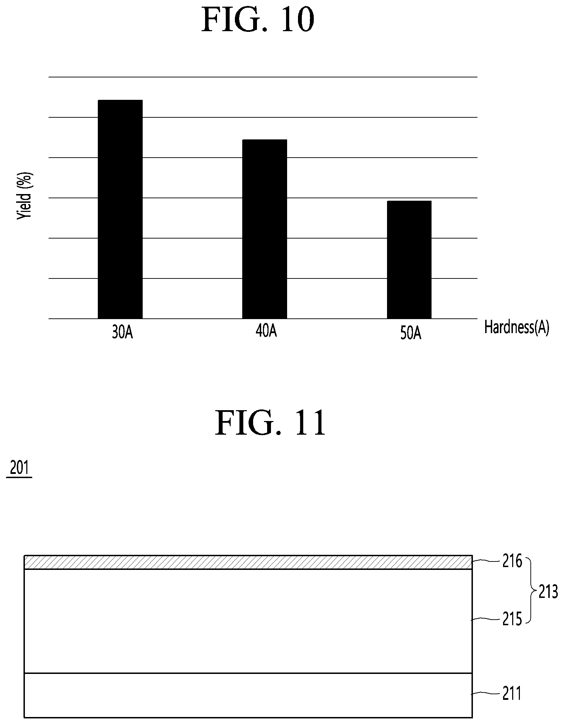

As illustrated in FIG. 11, the embodiment is such that a stamp member 213 in a transfer substrate 201 may be divided into a first layer 215 and a second layer 216, and the amount of the curing agent of each of the first layer 215 and the second layer 216 may be different. For example, the amount of the curing agent of the second layer 216 may be smaller than the amount of the curing agent of the first layer 215. Accordingly, the second layer 216 to which the semiconductor light-emitting element is attached may increase the tackiness to improve the yield. **In** addition, the first layer 215 may increase the hardness to prevent deformation of the transfer substrate 201, so that the alignment accuracy can be increased during the transfer of the semiconductor light-emitting element.

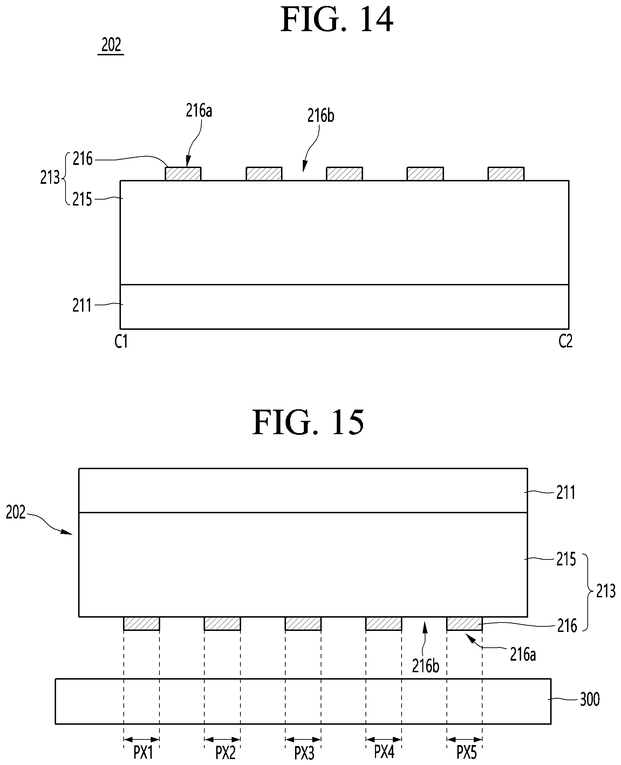

As illustrated in FIG. 14, the embodiment is such that the second layer 216 may comprise a plurality of protrusions 216a, and the plurality of protrusions 216a may have a size corresponding to a size of at least one or more pixel defined on the backplane substrate 300, so that the transfer process can be fast and the transfer process time can be shortened.

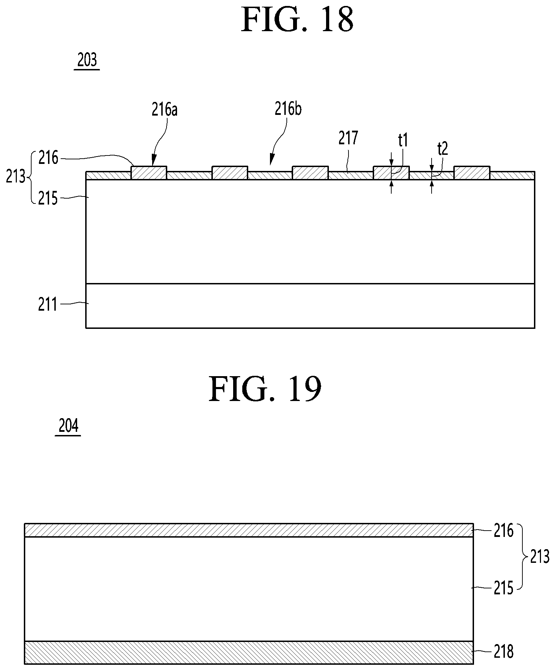

As illustrated in FIG. 18, the embodiment is such that a third layer 217 may be disposed between the plurality of protrusions 216a of the second layer 216, thereby preventing deformation of each of the plurality of protrusions 216a of the second layer 216.

As illustrated in FIG. 19, the embodiment is such that the third layer 217 may be disposed under the stamp member 213, i.e., the first layer 215, thereby having the function of the support member 211 illustrated in FIG. 11, FIG. 14, and FIG. 18, so that disposal of the transfer substrate 204 can be prevented due to the second deformation that occurs when attaching the support member 211 and the stamp member 213 using a double-sided tape.

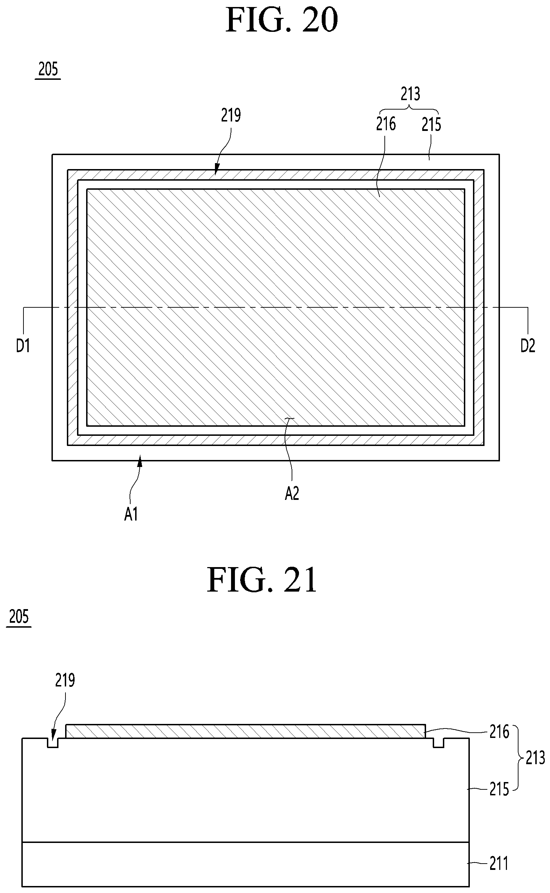

As illustrated in FIG. 21, a recess 219 may be formed along the perimeter of an outer side of the second layer 216 on the first layer 215, so that stress generated on the transfer substrate 205 during the transfer process may be absorbed by the recess 219. Thus, semiconductor light-emitting elements already transferred onto the peripheral block region 310 adjacent to a specific block region 310 to which the transfer substrate 205 is pressed may not be detached due to the stress. **In** addition, the semiconductor light-emitting elements already transferred onto the peripheral block region 310 can be prevented from being warped or bent, so that a lighting failure caused by electrical disconnection during a post-process can be prevented.

Additional scope of applicability of the embodiments will become apparent from the detailed description that follows. However, since various changes and modifications within the idea and scope of the embodiments may be clearly understood by those skilled in the art, the detailed description and specific embodiments, such as preferred embodiments, should be understood as being given by way of example only.

### [Description of Drawings]

FIG. 1 illustrates arrangement errors of a semiconductor light-emitting element that occurs during transfer of a transfer substrate.
FIG. 2 illustrates the propagation of stress generated in a transfer substrate progresses.
FIG. 3 illustrates a living room of a house in which a display device according to the embodiment is disposed.
FIG. 4 is a block diagram schematically showing a display device according to the embodiment.
FIG. 5 is a circuit diagram showing an example of a pixel of FIG. 4.
FIG. 6 is an enlarged view of a first panel region in the display device of FIG. 3.
FIG. 7 is a cross-sectional view illustrating a method for manufacturing a display device according to an embodiment.
FIG. 8 is a graph showing the relationship between Young's modulus and tackiness of an organic material.
FIG. 9 is a graph showing the amount of change in each of high-tack and low-tack materials according to the number of repeated evaluations.
FIG. 10 is a graph showing yield according to hardness.
FIG. 11 is a cross-sectional view illustrating a transfer substrate according to a first embodiment.
FIG. 12 is a flowchart illustrating a method for manufacturing a transfer substrate according to the first embodiment.
FIG. 13 is a plan view illustrating a transfer substrate according to a second embodiment.
FIG. 14 is a cross-sectional view illustrating a transfer substrate according to the second embodiment.
FIG. 15 illustrates the transfer substrate of FIG. 14 positioned on a backplane substrate.
FIG. 16 illustrates a plurality of semiconductor light-emitting elements picked up on a protrusion corresponding to a size of one pixel.
FIG. 17 is a cross-sectional view illustrating a method for manufacturing a transfer substrate according to the second embodiment.
FIG. 18 is a cross-sectional view illustrating a transfer substrate according to a third embodiment.
FIG. 19 is a cross-sectional view illustrating a transfer substrate according to a fourth embodiment.
FIG. 20 is a plan view illustrating a transfer substrate according to a fifth embodiment.
FIG. 21 is a cross-sectional view illustrating a transfer substrate according to the fifth embodiment.
FIG. 22 illustrates the propagation of stress generated in a transfer substrate according to the fifth embodiment progresses.

The sizes, shapes, dimensions, etc. of elements illustrated in the drawings may differ from actual ones. In addition, even if the same elements are illustrated in different sizes, shapes, dimensions, etc. between the drawings, this is only an example on the drawing, and the same elements have the same sizes, shapes, dimensions, etc. between the drawings.

### [Mode for Invention]

Hereinafter, the embodiment disclosed in this specification will be described in detail with reference to the accompanying drawings, but the same or similar elements are given the same reference numerals regardless of reference numerals, and redundant descriptions thereof will be omitted. The suffixes 'module' and 'unit' for the elements used in the following descriptions are given or used interchangeably in consideration of ease of writing the specification, and do not themselves have a meaning or role that is distinct from each other. In addition, the accompanying drawings are for easy understanding of the embodiment disclosed in this specification, and the technical idea disclosed in this specification is not limited by the accompanying drawings. Also, when an element such as a layer, region or substrate is referred to as being 'on' another element, this means that there may be directly on the other element or be other intermediate elements therebetween.

The display device described in this specification may comprise a TV, a signage, a mobile terminal such as a mobile phone or a smart phone, a computer display such as a laptop or a desktop, a head-up display (HUD) for an automobile, a backlight unit for a display, a display for extended reality (XR) such as AR, VR, and mixed reality (MR), a light source, etc. However, the configuration according to the embodiment described in this specification may be equally applied to a device capable of displaying, even if it is a new product type developed in the future.

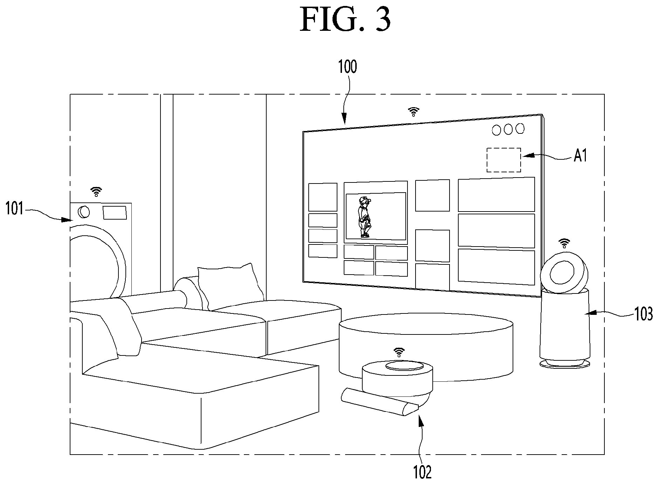

FIG. 3 illustrates a living room of a house in which a display device according to the embodiment is disposed.

Referring to FIG. 3, the display device 100 of the embodiment may display the status of various electronic products such as a washing machine 101, a robot vacuum cleaner 102, and an air purifier 103, and may communicate with each electronic product based on IoT and control each electronic product based on the user's setting data.

The display device 100 according to the embodiment may comprise a flexible display manufactured on a thin and flexible substrate. The flexible display may be bent or rolled like paper while maintaining the characteristics of a conventional flat panel display.

In the flexible display, visual information may be implemented by independently controlling the light emission of unit pixels disposed in a matrix form. A unit pixel means a minimum unit for implementing one color. The unit pixel of the flexible display may be implemented by a light-emitting element. In the embodiment, the light-emitting element may be a micro-LED or a nano-LED, but is not limited thereto.

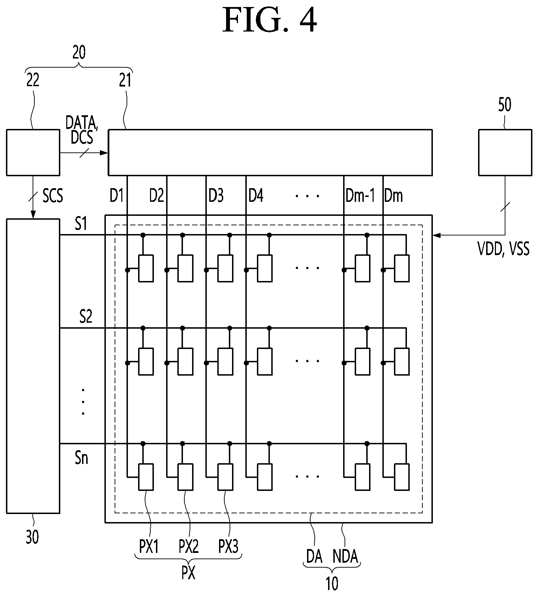

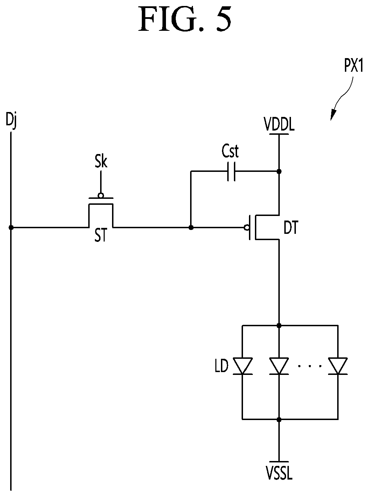

FIG. 4 is a block diagram schematically showing a display device according to the embodiment, and FIG. 5 is a circuit diagram showing an example of a pixel of FIG. 4.

Referring to FIGS. 4 and 5, the display device according to the embodiment may comprise a display panel 10, a driving circuit 20, a scan driving unit 30, and a power supply circuit 50.

The display device 100 of the embodiment may drive a light-emitting element in an active matrix (AM) mode or a passive matrix (PM) mode.

The driving circuit 20 may comprise a data driving unit 21 and a timing control unit 22.

The display panel 10 may be formed in a rectangular shape, but is not limited thereto. That is, the display panel 10 may be formed in a circular or oval shape. At least one side of the display panel 10 may be formed to be bent at a predetermined curvature.

The display panel may comprise a display region DA. The display region DA is a region where pixels PX are formed to display an image. The display panel may comprise a non-display region NDA. The non-display region NDA may be a region excluding the display region DA.

As an example, the display region DA and the non-display region NDA may be defined on the same surface. For example, the non-display region NDA may surround the display region DA on the same surface as the display region DA, but is not limited thereto.

As another example, although not illustrated in the drawing, the display region DA and the non-display region NDA may be defined on different surfaces. For example, the display region DA may be defined on the upper surface of the substrate, and the non-display region NDA may be defined on the lower surface of the substrate. For example, the non-display region NDA may be defined on the entire region or a part of the lower surface of the substrate.

Meanwhile, although the drawing illustrates that the display region DA and the non-display region NDA are divided, the display region DA and the non-display region NDA may not be divided. In other words, only the display region DA may exist on the upper surface of the substrate, and the non-display region NDA may not exist. In other words, the entire region of the upper surface of the substrate may be the display region DA where the image is displayed, and the bezel region, which is the non-display region NDA, may not exist.

The display panel 10 may comprise data lines (D1 to Dm, where m is an integer greater than or equal to 2), scan lines (S1 to Sn, where n is an integer greater than or equal to 2) intersecting the data lines D1 to Dm, a high-potential voltage line VDDL supplied with a high-potential voltage VDD, a low-potential voltage line VSSL supplied with a low-potential voltage VSS, and pixels PX connected to the data lines D1 to Dm and the scan lines S1 to Sn.

Each of the pixels PX may comprise a first subpixel PX1, a second subpixel PX2, and a third subpixel PX3. The first subpixel PX1 may emit a first color light of a first main wavelength, the second subpixel PX2 may emit a second color light of a second main wavelength, and the third subpixel PX3 may emit a third color light of a third main wavelength. The first color light may be red light, the second color light may be green light, and the third color light may be blue light, but the present invention is not limited thereto. In addition, although FIG. 4 exemplifies that each of the pixels PX comprises three subpixels, the present invention is not limited thereto. That is, each of the pixels PX may comprise four or more subpixels.

Each of the first subpixel PX1, the second subpixel PX2, and the third subpixel PX3 may be connected to at least one of the data lines D1 to Dm, at least one of the scan lines S1 to Sn, and a high-potential voltage line VDDL. The first subpixel PX1 may comprise light-emitting elements LD, a plurality of transistors for supplying current to the light-emitting elements LD, and at least one capacitor Cst, as illustrated in FIG. 5.

Although not illustrated in the drawing, each of the first subpixel PX1, the second subpixel PX2, and the third subpixel PX3 may comprise only one light-emitting element LD and at least one capacitor Cst.

Each of the light-emitting elements LD may be a semiconductor light-emitting diode comprising a first electrode, a plurality of conductive semiconductor layers, and a second electrode. Here, the first electrode may be an anode electrode, and the second electrode may be a cathode electrode, but is not limited thereto.

The light-emitting element LD may be one of a lateral-type light-emitting element, a flip-chip type light-emitting element, and a vertical-type light-emitting element.

The plurality of transistors may comprise a driving transistor DT for supplying current to the light-emitting elements LD, and a scan transistor ST for supplying a data voltage to a gate electrode of the driving transistor DT, as illustrated in FIG. 5. The driving transistor DT may comprise a gate electrode connected to a source electrode of the scan transistor ST, a source electrode connected to a high-potential voltage line VDDL to which a high-potential voltage VDD is applied, and a drain electrode connected to the first electrodes of the light-emitting elements LD. The scan transistor ST may comprise a gate electrode connected to a scan line (Sk, where k is an integer satisfying 1 ≤ k ≤ n), a source electrode connected to the gate electrode of the driving transistor DT, and a drain electrode connected to a data line (Dj, where j is an integer satisfying 1 ≤ j ≤ m).

A capacitor Cst is formed between the gate electrode and the source electrode of the driving transistor DT. The storage capacitor Cst charges a difference value between the gate voltage and the source voltage of the driving transistor DT.

The driving transistor DT and the scan transistor ST may be formed of a thin film transistor. In addition, in FIG. 5, the driving transistor DT and the scan transistor ST are described mainly as being formed as P-type metal oxide semiconductor field effect transistors (MOSFETs), but the present invention is not limited thereto. The driving transistor DT and the scan transistor ST may also be formed as N-type MOSFETs. In this instance, the positions of the source electrode and the drain electrode of each of the driving transistor DT and the scan transistors ST may be changed.

In addition, in FIG. 5, the first subpixel PX1, the second subpixel PX2, and the third subpixel PX3 are illustrated as comprising 2T1C (2 Transistor - 1 capacitor) having one driving transistor DT, one scan transistor ST, and one capacitor Cst, but the present invention is not limited thereto. The first subpixel PX1, the second subpixel PX2, and the third subpixel PX3 may each comprise a plurality of scan transistors ST and a plurality of capacitors Cst.

The second subpixel PX2 and the third subpixel PX3 may be expressed by substantially the same circuit diagram as the first subpixel PX1, so that detailed descriptions thereof will be omitted.

The driving circuit 20 outputs signals and voltages for driving the display panel 10. To this end, the driving circuit 20 may comprise a data driving unit 21 and a timing control unit 22.

The data driving unit 21 receives digital video data DATA and a source control signal DCS from the timing control unit 22. The data driving unit 21 converts the digital video data DATA into analog data voltages according to the source control signal DCS and supplies the converted data to the data lines D1 to Dm of the display panel 10.

The timing control unit 22 receives digital video data DATA and timing signals from a host system. The host system may be an application processor of a smartphone or tablet PC, a monitor, a system-on-chip of a TV, etc.

The timing control unit 22 generates control signals for controlling the operation timing of the data driving unit 21 and the scan driving unit 30. The control signals may comprise a source control signal DCS for controlling the operation timing of the data driving unit 21 and a scan control signal SCS for controlling the operation timing of the scan driving unit 30.

The driving circuit 20 may be disposed in a non-display region NDA provided on one side of the display panel 10. The driving circuit 20 may be formed as an integrated circuit (IC) and mounted on the display panel 10 using a chip on glass (COG) method, a chip on plastic (COP) method, or an ultrasonic bonding method, but the present invention is not limited thereto. For example, the driving circuit 20 may be mounted on a circuit board (not illustrated) other than the display panel 10.

The data driving unit 21 may be mounted on the display panel 10 using a chip on glass (COG) method, a chip on plastic (COP) method, or an ultrasonic bonding method, and the timing control unit 22 may be mounted on a circuit board.

The scan driving unit 30 receives a scan control signal SCS from the timing control unit 22. The scan driving unit 30 generates scan signals according to the scan control signal SCS and supplies them to the scan lines S1 to Sn of the display panel 10. The scan driving unit 30 may be formed in a non-display region NDA of the display panel 10 and comprise a plurality of transistors. Alternatively, the scan driving unit 30 may be formed as an integrated circuit, in which case it may be mounted on a gate flexible film attached to the other side of the display panel 10.

The power supply circuit 50 may generate voltages necessary for driving the display panel 10 from a main power applied from a system board and supply them to the display panel 10. For example, the power supply circuit 50 may generate a high-potential voltage VDD and a low-potential voltage VSS for driving the light-emitting elements LD of the display panel 10 from the main power supply and supply them to the high-potential voltage line VDDL and the low-potential voltage line VSSL of the display panel 10. In addition, the power supply circuit 50 may generate and supply driving voltages for driving the driving circuit 20 and the scan driving unit 30 from the main power supply.

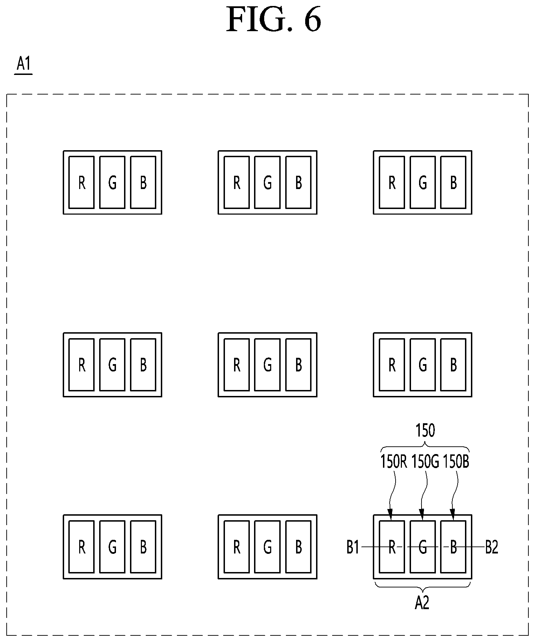

FIG. 6 is an enlarged view of the first panel region in the display device of FIG. 3.

Referring to FIG. 6, the display device 100 of the embodiment may be manufactured by mechanically and electrically connecting a plurality of panel regions such as the first panel region A1 by tiling.

The first panel region A1 may comprise a plurality of semiconductor light-emitting elements 150 disposed for each unit pixel (PX of FIG. 4).

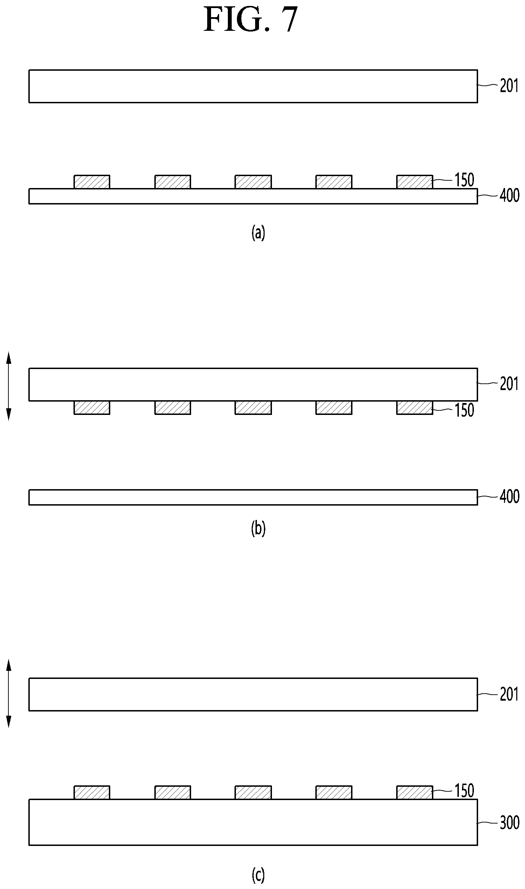

Hereinafter, various embodiments for solving the above-described problem will be described with reference to FIGS. 7 to 22. Any description omitted below may be easily understood from the descriptions described above with respect to FIGS. 3 to 6 and the corresponding drawings.

In the embodiment, the transfer substrate may be a substrate that transfers a plurality of semiconductor light-emitting elements from a wafer, a temporary substrate, or a donor substrate 400 (hereinafter referred to as a donor substrate) to a backplane substrate 300, a semiconductor substrate, a wiring substrate, or a display substrate (hereinafter referred to as a backplane substrate). One side of the transfer substrate may be mounted on a head part of a pick-and-place device (hereinafter referred to as a transfer device), and the other side of the transfer substrate may have tackiness. In this instance, the transfer substrate may be moved to the donor substrate 400 by the operation of the transfer device to pick up a plurality of semiconductor light-emitting elements on the donor substrate 400, and then moved to the backplane substrate 300 to place a plurality of semiconductor light-emitting elements on the backplane substrate 300. When the display region where the semiconductor light-emitting elements are to be placed on the backplane substrate 300 is tens to hundreds of times greater than an area of the transfer substrate, this transfer process may be repeatedly performed tens to hundreds of times. The semiconductor light-emitting elements described in other drawings except for FIG. 7 may be the semiconductor light-emitting elements 150 illustrated in FIG. 7 when no separate drawing reference is given to them.

FIG. 7 is a cross-sectional view illustrating a method for manufacturing a display device according to an embodiment.

As illustrated in FIG. 7A, a series of semiconductor processes may be performed to provide a plurality of semiconductor light-emitting elements 150 on the donor substrate 400. In the embodiment, the semiconductor light-emitting element 150 may be a vertical-type semiconductor light-emitting element 150. In the vertical-type semiconductor light-emitting element 150, electrodes may be formed not only on the upper side of the light-emitting layer but also on the lower side. Accordingly, after a semiconductor process is performed on the wafer to form the light-emitting layer and the upper electrode, the upper electrode may be bonded to a temporary substrate. Then, after the wafer is separated, a lower electrode may be formed on the lower side of the light-emitting layer that is separated and exposed. Then, the lower electrode may be bonded to the donor substrate 400 and the temporary substrate may be removed, thereby manufacturing the donor substrate 400 illustrated in FIG. 7A. At this time, the lower electrode of the semiconductor light-emitting element 150 may be loosely bonded to the donor substrate 400. That is, the tackiness of the lower surface of the transfer substrate 201, i.e., the tack surface, may be greater than the tackiness of the donor substrate 400 that is in contact with the semiconductor light-emitting element 150.

As illustrated in FIG. 7B, the transfer substrate 201 may be lowered and pressed against the donor substrate 400, and then raised again, so that a plurality of semiconductor light-emitting elements 150 on the donor substrate 400 may be picked up onto the transfer substrate 201. At this time, a plurality of semiconductor light-emitting elements 150 on a region corresponding to an area of the transfer substrate 201 may be picked up from the donor substrate 400 onto the transfer substrate 201 .

As illustrated in FIG. 7C, the transfer substrate 201 on which the plurality of semiconductor light-emitting elements 150 are picked up may be moved onto the backplane substrate 300, and then an alignment process may be performed so that the transfer substrate 201 and the backplane substrate 300 may be aligned.

After that, the transfer substrate 201 may be lowered and pressed, and then raised again, so that a plurality of semiconductor light-emitting elements 150 on the transfer substrate 201 may be placed on the backplane substrate 300.

A series of transfer processes illustrated in FIGS. 7A to 7C may be repeatedly performed.

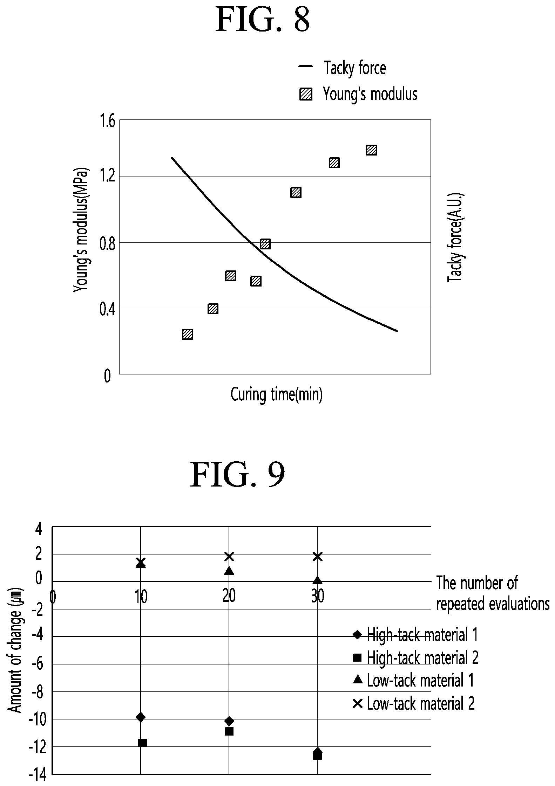

Meanwhile, before explaining the transfer substrates 201 to 205 according to the embodiment, various variable relationships related to the transfer substrate will be explained with reference to FIGS. 8 to 10.

FIG. 8 is a graph showing the relationship between Young's modulus and tackiness of an organic material.

As illustrated in FIG. 8, Young's modulus is inversely proportional to tackiness.

Young's modulus is a mechanical property that measures the hardness of a solid material under a certain pressure, and may be used interchangeably with stiffness in embodiments. Specifically, Young's modulus may be an elastic coefficient that defines the relationship between stress and strain of a linear elastic material in a uniaxial strain region. For example, when Young's modulus is E, it may be expressed as F (stress) = E (Young's modulus) × S (strain). Therefore, for a material with a large Young's modulus, the strain is small under the same pressure.

The Tacky force indicated in FIG. 8 refers to a tackiness, and in the case of organic materials, the sticky property of the surface vary depending on the hardness. That is, in the case of organic materials, looking at the graph of FIG. 8, in the case of organic materials, as the curing time passes, the Young's modulus increases and the tackiness changes in the direction of decreasing. In other words, as the organic material hardens, the degree of deformation under the same pressure increases, while the tackiness decreases.

Therefore, when the hardness is large, the tackiness decreases, and when the hardness decreases, the tackiness may increase.

FIG. 9 is a graph showing the amount of change in each of high-tack and low-tack materials according to the number of repeated evaluations.

As illustrated in FIG. 9, as the number of repeated evaluations increases, the amount of change in the high-tack material is much greater than the amount of change in the low-tack material. Therefore, when a low-tack material is used as a transfer substrate, the possibility of alignment errors decreases, and when a high-tack material is used, the possibility of alignment errors may increase.

FIG. 10 is a graph showing yield according to hardness.

As illustrated in FIG. 10, it may be seen that the yield decreases as the hardness increases. Therefore, in order to increase the yield, an organic material with low hardness may be used as a transfer substrate.

On the other hand, as illustrated in FIG. 1, in the case of the existing transfer substrate 1, due to the material property of the organic material, deformation (or stretching) occurs as the transfer process is repeated, and there is a problem that a lighting failure occurs due to a transfer defect caused by an alignment error.

As illustrated in FIG. 10, in order to increase the yield, an organic material with excellent tackiness but low hardness may be used as a transfer substrate. However, as illustrated in FIG. 8, there is a problem that when the tackiness is high, the hardness decreases, which increases the possibility of alignment errors.

On the contrary, in order to reduce the possibility of alignment errors, an organic material with high hardness but low tackiness may be used as a transfer substrate. However, as illustrated in FIG. 10, when the hardness is high, the tackiness decreases, which reduces the yield.

In summary, in the case of organic materials, hardness and tackiness are inversely proportional, but an increase in hardness (or a decrease in tackiness) may lead to a decrease in yield, and a decrease in hardness (or an increase in tackiness) may lead to an increase in the possibility of alignment errors. In other words, the yield and the possibility of alignment errors may also be inversely proportional. Accordingly, development of a transfer substrate that may reduce alignment errors and increase yield is urgently required.

Hereinafter, various embodiments of a transfer substrate will be described with reference to FIGS. 11 to 22.

### [First Embodiment]

FIG. 11 is a cross-sectional view illustrating a transfer substrate according to a first embodiment.

Referring to FIG. 11, the transfer substrate 201 according to the first embodiment may comprise a stamp member 213.

The stamp member 213 may comprise a first layer 215 and a second layer 216. The second layer 216 may be disposed on the first layer 215. A lower surface of the second layer 216 may be in contact with an upper surface of the first layer 215.

The first layer 215 may be a deformation (or stretching) prevention layer, and the second layer 216 may be a tack layer.

A lower surface of the first layer 215 may be positioned toward a head part of the transfer device, and an upper surface of the second layer 216 may be positioned toward the donor substrate 400 or the backplane substrate 300.

The first layer 215 may comprise an organic material. The first layer 215 may comprise a silicon material. For example, the first layer 215 may comprise polydimethylsiloxane (PDMS), but is not limited thereto. The first layer 215 may comprise an inorganic filler.

The first layer 215 may comprise an inorganic filler. The main component of the inorganic filler may be SiO₂ having a thickness of tens of nm to several µm, but is not limited thereto. The hardness of the first layer 215 may be controlled by the concentration of the inorganic filler. In an embodiment, the first layer 215 serves to support the second layer 216 and must suppress the possibility of alignment errors, so that the concentration of the inorganic filler may be relatively high.

The first layer 215 may comprise a curing agent. The hardness (or tackiness) of the first layer 215 may be controlled by the amount of the curing agent. That is, as the amount of the curing agent increases, the hardness of the first layer 215 increases, but the tackiness may decrease. Conversely, as the amount of the curing agent decreases, the hardness of the first layer 215 decreases, but the tackiness may increase.

In an embodiment, the first layer 215 serves to support the second layer 216 and must suppress the possibility of alignment errors, so that the amount of the curing agent may be relatively high.

The second layer 216 may comprise an organic material. The second layer 216 may comprise a silicone material. The second layer 216 may comprise the same organic material as the first layer 215. For example, the second layer 216 may comprise PDMS, but is not limited thereto.

The second layer 216 may comprise an inorganic filler. The second layer 216 may comprise the same inorganic filler as the first layer 215, but is not limited thereto. The hardness of the second layer 216 may be controlled by the concentration of the inorganic filler. In an embodiment, the second layer 216 may have a relatively low concentration of the inorganic filler since the yield must be increased. For example, the concentration of the inorganic filler in the second layer 216 may be lower than the concentration of the inorganic filler in the first layer 215. For example, the concentration of the inorganic filler of the second layer 216 may be at least three times lower than the concentration of the inorganic filler of the first layer 215.

The first layer 215 may comprise a curing agent. The hardness (or tackiness) of the second layer 216 may be controlled by the amount of the curing agent. That is, as the amount of the curing agent increases, the hardness of the first layer 215 may increase, but the tackiness may decrease. Conversely, as the amount of the curing agent decreases, the hardness of the first layer 215 may decrease, but the tackiness may increase.

In an embodiment, the amount of the curing agent of the second layer 216 may be relatively low because the yield must be increased. The amount of the curing agent of the second layer 216 may be smaller than the amount of the curing agent of the first layer 215. In this instance, the tackiness of the second layer 216 may be greater than the tackiness of the first layer 215, and the hardness of the second layer 216 may be greater than the hardness of the first layer 215 (FIGS. 8 to 10).

For example, the amount of the curing agent of the first layer 215 may be 11 wt% to 13 wt%, but is not limited thereto. For example, the amount of the curing agent of the second layer 216 may be 9 wt% to 10 wt%, but is not limited thereto.

Meanwhile, although the thickness of the first layer 215 is illustrated as being greater than the thickness of the second layer 216 in the drawing, the thickness of the first layer 215 may be equal to or greater than the thickness of the second layer 216. That is, even if the thickness of the first layer 215 is small, the desired hardness and tackiness may be maintained by controlling the concentration of the inorganic filler and/or the amount of the curing agent of the first layer 215.

Therefore, when the transfer substrate 201 according to the first embodiment is mounted on a head part of the electronic device and the transfer process is performed, the first layer 215 may increase the hardness of the transfer substrate 201, so that even if the repeated transfer process is performed, the arrangement errors of the plurality of semiconductor light-emitting elements 150 can be prevented or minimized. In addition, the second layer 216 may increase the tackiness of the transfer substrate 201, thereby improving the yield. That is, the higher the tackiness of the transfer substrate 201, the more likely it is that the plurality of semiconductor light-emitting devices 150 are picked up from the donor substrate 400 onto the transfer substrate 201 without omission, and the plurality of semiconductor light-emitting devices 150 are placed onto the backplane substrate 300 without omission.

Meanwhile, the transfer substrate 201 according to the first embodiment may comprise a support member 211. When the first layer 215 of the stamp member 213 prevents arrangement errors of the semiconductor light-emitting element 150 while having the function of the support member 211, the support member 211 may be omitted.

The support member 211 may support the stamp member 213 and enable the stamp member 213 to be easily and stably mounted on the head part of the transfer device. In addition, the support member 211 may enable the stamp member 213 to be easily and stably detached from the head part of the transfer device. The support member 211 may enable the pressing force of the head part of the transfer device to be uniformly transmitted to the entire region of the stamp member 213. Accordingly, the support member 211 may be made of a material having excellent support strength.

The support member 211 may be disposed under the first layer 215. The support member 211 may comprise an organic material different from the first layer 215, but is not limited thereto. The second layer 216 may comprise a plastic material or glass. As the plastic material, polyethylene terephthalate (PET), polycarboxylate ether (PCE), etc. may be used.

The support member 211 may be attached to the stamp member 213 using a double-sided tape, but is not limited thereto. For example, after the double-sided tape is positioned between the stamp member 213 and the support member 211, the stamp member 213 and/or the support member 211 are pressed, so that the support member 211 may be attached to the stamp member 213 using the double-sided tape.

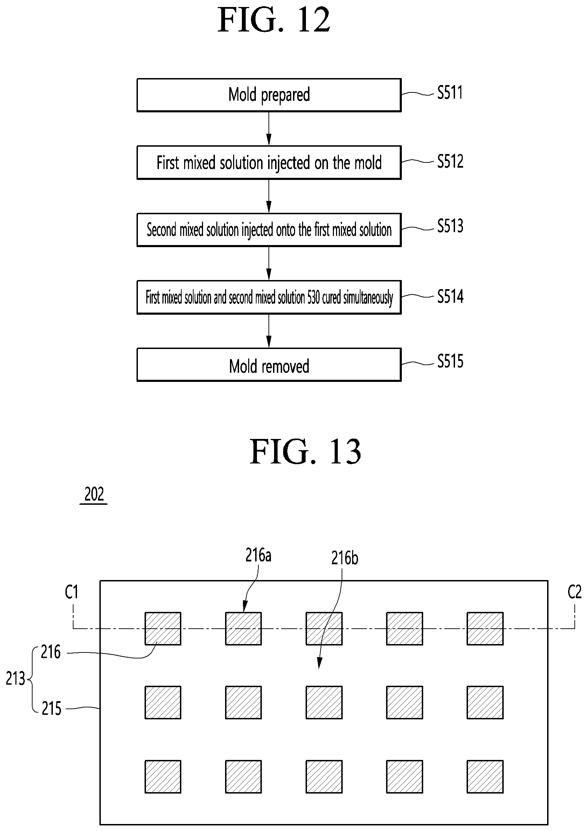

Figure 12 is a flowchart illustrating a method for manufacturing a transfer substrate according to the first embodiment.

As illustrated in FIG. 11 and FIG. 12, a mold 500 may be prepared (S511).

A groove corresponding to the size of the transfer substrate 201 may be provided inside the mold 500.

A first mixed solution 520 may be injected onto the mold 500. For example, the first mixed solution 520 may be injected into the groove of the mold 500 (S512).

The first mixed solution 520 is a solution for forming the second layer 216, and may be made by mixing an organic material, a curing agent, etc. The first mixed solution 520 may comprise an inorganic filler, but is not limited thereto. The injection amount of the first mixed solution 520 may be determined in consideration of the thickness of the second layer 216.

The second mixed solution 530 may be injected onto the first mixed solution 520 (S513). For example, the second mixed solution 530 may be injected onto the first mixed solution 520 within the groove of the mold 500.

The second mixed solution 530 is a solution for forming the first layer 215, and may be made by mixing an organic material, a curing agent, etc. The second mixed solution 530 may comprise an inorganic filler, but is not limited thereto. The injection amount of the second mixed solution 530 may be determined considering the thickness of the first layer 215.

The organic material of the second mixed solution 530 may be the same as the organic material of the first mixed solution 520, but is not limited thereto. The curing agent of the second mixed solution 530 may be the same as the curing agent of the first mixed solution 520, but is not limited thereto. The inorganic filler of the second mixed solution 530 may be the same as the inorganic filler of the first mixed solution 520, but is not limited thereto.

Meanwhile, since the first mixed solution 520 and the second mixed solution 530 comprise a relatively high viscosity silicone material as an organic material and have different contents of a curing agent, the first mixed solution 520 and the second mixed solution 530 injected into the groove of the mold 500 may not be mixed at the interface but may form independent layers with each other.

In this way, the first mixed solution 520 and the second mixed solution 530 formed as independent layers within the groove of the mold 500 may be cured simultaneously (S514). Accordingly, the cured first mixed solution 520 may be formed as the first layer 215, and the cured second mixed solution 530 may be formed as the second layer 216 positioned on the first layer 215. Accordingly, a stamp member 213 comprising a first layer 215 and a second layer 216 may be formed.

Thereafter, the stamp member 213 may be attached to the support member 211 using a double-sided tape, but is not limited thereto. For example, after the double-sided tape is positioned between the first layer 215 of the stamp member 213 and the support member 211, the first layer 215 of the stamp member 213 and/or the mold 500 are pressed, so that the support member 211 may be attached to the stamp member 213 via the double-sided tape.

Thereafter, the mold 500 may be removed (S515), so that a transfer substrate 201 comprising the stamp member 213 and the support member 211 may be manufactured.

In the above, the second layer 216, the first layer 215, and the support member 211 are described as being formed in the order, but the support member 211, the first layer 215, and the second layer 216 may be formed in the order. Alternatively, the first layer 215 and the second layer 216 may be formed in the order on the mold 500, and after the mold 500 is removed, the support member 211 may be formed under the first layer 215.

### [Second embodiment]

FIG. 13 is a plan view illustrating a transfer substrate according to a second embodiment. FIG. 14 is a cross-sectional view illustrating a transfer substrate according to the second embodiment.

The second embodiment is the same as the first embodiment except that the second layer 216 comprises a plurality of protrusions 216a and a recess 216b. In the second embodiment, components having the same shape, structure, and/or function as those of the first embodiment are given the same drawing reference numerals, and detailed descriptions thereof will be omitted.

Referring to FIGS. 13 and 14, the transfer substrate 202 according to the second embodiment may comprise a support member 211 and a stamp member 213. When the first layer 215 of the stamp member 213 prevents the arrangements errors of the semiconductor light-emitting elements 150 while having the function of the support member 211, the support member 211 may be omitted.

The stamp member 213 may be disposed on the support member 211.

The support member 211 may be mounted on the head part of the transfer device. The stamp member 213 may be configured to prevent the arrangements errors of the semiconductor light-emitting elements 150 while increasing the yield.

The stamp member 213 may comprise a first layer 215 and a second layer 216. The first layer 215 may be disposed on the support member 211. The first layer 215 may be in contact with an upper surface of the support member 211. The second layer 216 may be disposed on the first layer 215. The second layer 216 may be in contact with an upper surface of the first layer 215.

In an embodiment, the second layer 216 may comprise a plurality of protrusions 216a and a recess 216b. The protrusions 216a may protrude from an upper surface of the first layer 215 toward an upward direction. As illustrated in FIG. 13, the protrusions 216a may have a square shape when viewed from above, but are not limited thereto.

The plurality of protrusions 216a may be spaced apart from each other, and the spaced-apart space may be a recess 216b. At this time, the width (or gap) of the recess 216b may be designed in consideration of the gap or margin between pixels.

That is, the recess 216b may be positioned along the perimeter of each of the plurality of protrusions 216a. The recess 216b positioned along the perimeter of each of the plurality of protrusions 216a may be connected to each other. The depth of the recess 216b may be determined by the thickness (or height) of the protrusion 216a. That is, the depth of the recess 216b may be the same as the thickness of the protrusion 216a. The greater the thickness of the protrusion 216a, the greater the depth of the recess 216b.

Meanwhile, the plurality of protrusions 216a may each correspond to a pixel defined on the backplane substrate 300. As illustrated in FIG. 15, the transfer substrate 202 according to the second embodiment may be positioned on the backplane substrate 300 with the plurality of semiconductor light-emitting elements 150 picked up. In this instance, the plurality of protrusions 216a of the transfer substrate 202 may each have a size corresponding to the size of at least one pixel PX1 to PX5. The protrusions 216a may have a shape corresponding to a shape of the pixel PX1 to PX5. For example, when the pixel PX1 to PX5 have a square shape, the protrusions 216a may also have a square shape.

The pixel PX1 to PX5 may comprise a plurality of semiconductor light-emitting elements 150. That is, the pixel PX1 to PX5 may comprise a plurality of subpixels. In this instance, the subpixel may comprise at least one or more semiconductor light-emitting element 150.

For example, the pixel PX1 to PX5 may comprise a first subpixel, a second subpixel, and a third subpixel. In this instance, the first subpixel may comprise at least or more one first semiconductor light-emitting element 150R. The second subpixel may comprise at least one or more second semiconductor light-emitting element 150G. The third subpixel may comprise at least or more one third semiconductor light-emitting element 150B. For example, the first semiconductor light-emitting element 150R may comprise a red semiconductor light-emitting element that emits red light, the second semiconductor light-emitting element 150G may comprise a green semiconductor light-emitting element that emits green light, and the third semiconductor light-emitting element 150B may comprise a blue semiconductor light-emitting element that emits blue light.

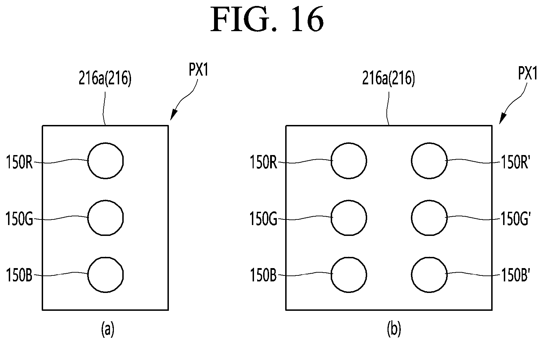

When the protrusion 216a has a size corresponding to a size of the pixel PX1 to PX5 comprising the first subpixel to the third subpixel, as illustrated in FIG. 16A, the first semiconductor light-emitting elements 150R to the third semiconductor light-emitting elements 150B disposed in a row among the plurality of semiconductor light-emitting elements 150 on the donor substrate 400 may be picked up on the protrusion 216a of the transfer substrate 202. When the first semiconductor light-emitting elements 150R to the third semiconductor light-emitting elements 150B picked up on the protrusion 216a of the transfer substrate 202 are placed on the backplane substrate 300, the first semiconductor light-emitting elements 150R to the third semiconductor light-emitting elements 150B may be positioned on each of the first subpixels to the third subpixels of the pixel PX1 to PX5 on the backplane substrate 300. In this instance, the first semiconductor light-emitting element 150R to the third semiconductor light-emitting element 150B may be transferred onto the pixel PX1 to PX5 corresponding to the number of protrusions 216a of the transfer substrate 202 by a single transfer process of the transfer substrate 202, respectively. For example, when 100 pixels are defined on the backplane substrate 300 and the number of protrusions 216a of the transfer substrate 202 is 50, the semiconductor light-emitting elements 150 may be transferred onto all the pixels of the backplane substrate 300 by two transfer processes using the transfer substrate 202.

Meanwhile, the pixel PX1 to PX5 may comprise a fourth subpixel in addition to the first to third subpixels. The fourth subpixel may not have semiconductor light-emitting elements 150R, 150G, and 150B disposed therein.

In addition, the pixel PX1 to PX5 may comprise one or more additional subpixels in addition to the first to third subpixels. Each of the additional subpixels may comprise at least one or more semiconductor light-emitting element among the first to third semiconductor light-emitting elements 150R to 150B. For example, the fourth subpixel may comprise the first semiconductor light-emitting element 150R, the fifth subpixel may comprise the second semiconductor light-emitting element 150G, and the sixth subpixel may comprise the third semiconductor light-emitting element 150B.

As illustrated in FIGS. 15 and 16B, the protrusion 216a may have a size corresponding to a size of one pixel PX1 to PX5. At this time, the pixel PX1 to PX5 may comprise six subpixels.

In this instance, the first semiconductor light-emitting element 150R to the third semiconductor light-emitting element 150B may be positioned in each of the first to third subpixels, and the fourth semiconductor light-emitting element 150R' to the sixth semiconductor light-emitting element 150B' may be positioned in each of the fourth to sixth subpixels. The first semiconductor light-emitting element 150R and the fourth semiconductor light-emitting element 150R' may each emit red light. The second semiconductor light-emitting element 150G and the fifth semiconductor light-emitting element 150G' may each emit green light. The third semiconductor light-emitting element 150B and the sixth semiconductor light-emitting element 150B' may each emit blue light.

For example, the fourth semiconductor light-emitting element 150R' to the sixth semiconductor light-emitting element 150B' are redundancy semiconductor light-emitting elements and may be used as replacements when the first semiconductor light-emitting element 150R to the third semiconductor light-emitting element 150B have a lighting failure. For example, when a display device comprising the backplane substrate 300 is driven to implement a display, the fourth semiconductor light-emitting element 150R' may be used as a replacement for the first semiconductor light-emitting element 150R when the first semiconductor light-emitting element 150R has a lighting failure. Accordingly, even if a specific semiconductor light-emitting element has a lighting failure when implementing a display, a replacement semiconductor light-emitting element lights up, so that a deterioration in image quality can be prevented.

Meanwhile, a first pixel may be defined by a first subpixel to a third subpixel, in which the first semiconductor light-emitting element 150R to the third semiconductor light-emitting element 150B are positioned, respectively, and a second pixel may be defined by a fourth subpixel to a sixth subpixel, in which the fourth semiconductor light-emitting element 150R' to the sixth semiconductor light-emitting element 150B' are positioned, respectively. In this instance, as illustrated in FIG. 16B, two pixels, i.e., the first pixel and the second pixel, corresponding to the first semiconductor light-emitting element 150R to the sixth semiconductor light-emitting element 150B' may be transferred onto the backplane substrate 300 by one protrusion 216a.

Accordingly, a plurality of semiconductor light-emitting elements may be transferred onto pixels in a quantity that is twice the number of protrusions 216a of the transfer substrate 202. For example, when 100 pixels are defined on the backplane substrate 300 and the number of protrusions 216a of the transfer substrate 202 is 50, the semiconductor light-emitting elements may be transferred onto all pixels of the backplane substrate 300 by a single transfer process using the transfer substrate 202.

Although not illustrated, the protrusions 216a may have a size corresponding to a size of three or more subpixels.

According to an embodiment, the second layer 216 comprises a plurality of protrusions 216a, and each protrusion 216a has a size corresponding to a size of at least or more one pixel, so that alignment adjustment for each of the plurality of pixels of the backplane substrate 300 may be facilitated and the accuracy of the alignment can be increased. In addition, according to the embodiment, since adjacent protrusions 216a are not affected by each other, even if deformation occurs in a specific protrusion 216a, the peripheral protrusions 216a are not affected by the deformation of the specific protrusion 216a, so that an increase in cost due to disposal of the backplane substrate 300 during the transfer process can be prevented.

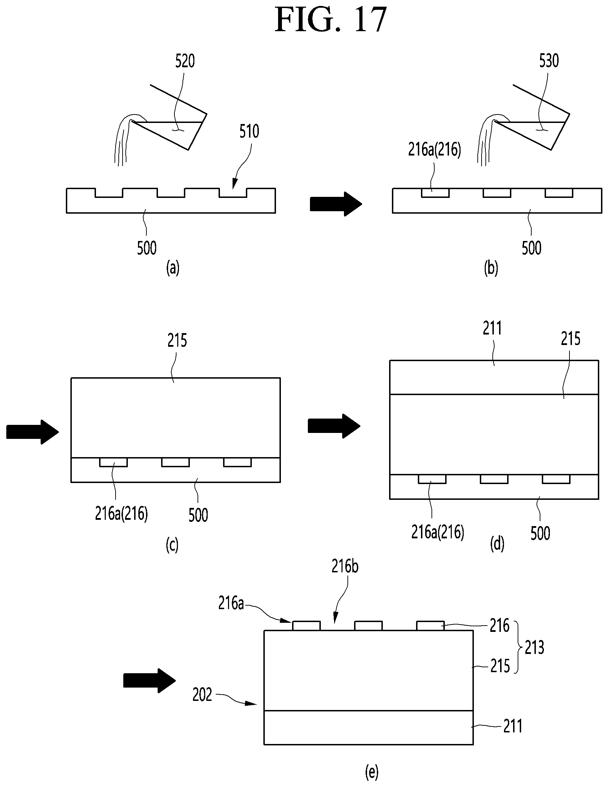

FIG. 17 is a cross-sectional view illustrating a method for manufacturing a transfer substrate according to the second embodiment.

As illustrated in FIG. 17A, a mold 500 having a plurality of negative patterns 510 may be prepared.

As illustrated in FIG. 17B, a first mixed solution 520 may be injected onto the mold 500. The first mixed solution 520 may be a solution for forming the second layer 216. In this instance, the first mixed solution 520 may be filled into the plurality of negative patterns 510 of the mold 500. Thereafter, the first mixed solution 520 overflowing from the plurality of negative patterns 510 may be removed using a squeegee. Accordingly, the first mixed solution 520 may be filled only into the plurality of negative patterns 510.

Meanwhile, the second mixed solution 530 may be injected onto the mold 500 (S530). Accordingly, as illustrated in FIG. 17C, the second mixed solution 530 may be formed on the first mixed solution 520. In this instance, the first mixed solution 520 and the second mixed solution 530 may remain unmixed, and may exist as separate layers centered around the interface between the first mixed solution 520 and the second mixed solution 530.

Thereafter, the first mixed solution 520 and the second mixed solution 530 may be hardened, thereby forming the stamp member 213.

As illustrated in FIG. 17D, the support member 211 may be attached to the stamp member 213 using a double-sided tape, but is not limited thereto.

First, the support member 211 may be positioned on the first layer 215 of the stamp member 213, and a double-sided tape may be positioned between the support member 211 and the stamp member 213. One side of the double-sided tape may be attached to the upper surface of the first layer 215 of the stamp member 213 or the lower surface of the support member 211 in advance. Thereafter, the first layer 215 of the stamp member 213 and/or the mold 500 may be pressed, thereby allowing the stamp member 213 to be attached to the support member 211 via the double-sided tape.

As illustrated in FIG. 17E, by removing the mold 500, a transfer substrate 202 comprising the stamp member 213 and the support member 211 may be manufactured.

### [Third Embodiment]

FIG. 18 is a cross-sectional view illustrating a transfer substrate according to a third embodiment.

The third embodiment is the same as the second embodiment except for the third layer 217. **In** the third embodiment, components having the same shape, structure, and/or function as those in the second embodiment are given the same drawing reference numerals and detailed descriptions thereof will be omitted.

Referring to FIG. 18, the transfer substrate 203 according to the third embodiment may comprise a support member 211 and a stamp member 213. When the first layer 215 of the stamp member 213 prevents the arrangements errors of the semiconductor light-emitting elements while having the function of the support member 211, the support member 211 may be omitted.

The stamp member 213 may comprise a first layer 215 and a second layer 216. The first layer 215 may be disposed on the support member 211. The first layer 215 may be in contact with an upper surface of the support member 211. The second layer 216 may be disposed on the first layer 215. The second layer 216 may be in contact with an upper surface of the first layer 215.

**In** an embodiment, the second layer 216 may comprise a plurality of protrusions 216a and a recess 216b. The protrusions 216a may protrude from an upper surface of the first layer 215 toward an upward direction.

The plurality of protrusions 216a may be spaced apart from each other, and the spaced apart space may be a recess 216b. That is, the recess 216b may be positioned around each of the plurality of protrusions 216a.

Since the plurality of protrusions 216a are spaced apart from each other, when the transfer process is repeated, the plurality of protrusions 216a may be deformed (or stretched) in the lateral direction by continuous pressure by the first layer 215. There is a problem that arrangement errors of the semiconductor light-emitting element occur due to this deformation, resulting in a lighting failure.

To solve this problem, in the embodiment, the stamp member 213 may comprise a third layer 217. The third layer 217 may be disposed in the recess 216b.

The third layer 217 may prevent the occurrence of deformation of the second layer 216. That is, since the third layer 217 is embedded in the recess 216b, the third layer 217 may be in contact with the side surface of each of the protrusions 216a adjacent to the bottom surface of the recess 216b. Accordingly, when the pressing force of the first layer 215 is transmitted to the protrusion 216a of the second layer 216, causing the protrusion 216a of the second layer 216 to stretch in the lateral direction, the stretching may be suppressed by the third layer 217 disposed in the recess 216b. Accordingly, even if the transfer process is repeatedly performed, since the protrusion 216a of the second layer 216 is not stretch in the lateral direction by the third layer 217, occurrence of an arrangement error of the semiconductor light-emitting element 150 may be prevented, thereby preventing a lighting failure.

**In** order for the third layer 217 to prevent the stretching of the second layer 216, the third layer 217 may comprise the same organic material as the first layer 215 and the second layer 216. At this time, the amount of the curing agent of the third layer 217 may be equal to or smaller than the amount of the curing agent of the first layer 215. The amount of the curing agent of the third layer 217 may be greater than the amount of the curing agent of the protrusion 216a of the second layer 216. For example, the amount of the curing agent of the third layer 217 may exceed 10 wt% and be equal to or smaller than 13 wt%. Accordingly, the tackiness of the third layer 217 may be equal to or greater than the tackiness of the first layer 215. The tackiness of the third layer 217 may be smaller than the tackiness of the second layer 216. The hardness of the third layer 217 may be equal to or smaller than that of the first layer 215. The hardness of the third layer 217 may be greater than that of the second layer 216.

The thickness t2 of the third layer 217 may be smaller than the thickness t1 of the protrusion 216a, but is not limited thereto. Accordingly, the third layer 217 and the protrusion 216a are clearly distinguished, which facilitates alignment, and the third layer 217 may not be damaged by impact to the partition wall of the backplane substrate during transfer of the transfer substrate 203.

Meanwhile, in FIG. 18, the first layer 215 and the third layer 217 are distinguished as independent layers, but the first layer 215 and the third layer 217 may be formed integrally. That is, the third layer 217 may be an extension part that extends to the first layer 215. **In** other words, the extension part may extend from the first layer 215 to the recess 216b between the adjacent protrusions 216a of the second layer 216.

For example, after the first layer 215 and the third layer 217 are simultaneously formed on the mold 500 using the same molding process and the mold 500 is removed, the protrusion 216a of the second layer 216 may be formed on the third layer 217, that is, on a region where the extension part is not formed, on the first layer 215, thereby manufacturing the stamp member 213.

### [Fourth Embodiment]

FIG. 19 is a cross-sectional view illustrating a transfer substrate according to a fourth embodiment.

The fourth embodiment is the same as the first embodiment except for the fourth layer 218. **In** the fourth embodiment, components having the same shape, structure, and/or function as those in the first embodiment are given the same drawing reference numerals and detailed descriptions thereof will be omitted. The fourth embodiment may be applied equally to the second embodiment or the third embodiment.

Referring to FIG. 19, the transfer substrate 204 according to the fourth embodiment may comprise a stamp member 213. The stamp member 213 may comprise a first layer 215 and a second layer 216.

The transfer substrate 204 according to the fourth embodiment may comprise a fourth layer 218.

The fourth layer 218 may be disposed under the stamp member 213. The fourth layer 218 may be disposed under the first layer 215 of the stamp member 213. The fourth layer 218 may be in contact with a lower surface of the first layer 215 of the stamp member 213.

In the embodiment, it is named as the fourth layer 218 to distinguish it from the third layer 217 illustrated in FIG. 18, but it may also be named as the third layer 217 considering the number of layers illustrated in FIG. 19.

The fourth layer 218 may comprise the same organic material as the first layer 215 and the second layer 216. That is, the first layer 215, the second layer 216, and the fourth layer 218 may comprise a silicone material. For example, the first layer 215, the second layer 216, and the fourth layer 218 may comprise PDMS, but are not limited thereto.

The amount of the curing agent of the fourth layer 218 may be greater than the amount of the curing agent of the first layer 215. The amount of the curing agent of the fourth layer 218 may be greater than the amount of the curing agent of the second layer 216. For example, the amount of the curing agent of the fourth layer 218 may be at least twice greater than the amount of the curing agent of the second layer 216. For example, for example, the amount of the curing agent of the fourth layer 218 may be 20 wt% or greater. Accordingly, the hardness of the fourth layer 218 may be greater than the hardness of the first layer 215 or the second layer 216, and the tackiness of the fourth layer 218 may be smaller than the tackiness of the first layer 215 or the second layer 216.

The fourth layer 218 may replace the support member 211 of the transfer substrate 204 according to the first embodiment. That is, the fourth layer 218 may have the function of the corresponding support member 211.

As described above, the support member 211 may be attached to the stamp member 213 using a double-sided tape. When the support member 211 or the stamp member 213 is pressed for such attachment, deformation (or stretching) may occur in the stamp member 213, particularly in the second layer 216. When the stamp member 213 is attached to the support member 211 in such a state of deformation, the alignment position set on the stamp member 213 may be disturbed, and the deformation may be continuously caused by the repeated pressing of the deformed second layer 216 during the repeated transfer process. Accordingly, there is a problem that the arrangements errors of the semiconductor light-emitting elements 150 continuously occur, resulting in the disposal of the transfer substrate 204.

To solve this problem, according to the embodiment, since a double-sided tape is not used, a pressurizing process is not required, and thus deformation of the second layer 216 of the stamp member 213 may not occur. That is, the first layer 215, the second layer 216, and the fourth layer 218 may be formed using a molding process.

For example, after S513 illustrated in FIG. 12 is performed, a third mixed solution may be injected onto the mold 500. The third mixed solution may be injected onto the second mixed solution 530 injected into the groove of the mold 500. The third mixed solution may be a solution for forming the fourth layer 218, and may be made by mixing an organic material, a curing agent, etc. The second mixed solution 530 may comprise an inorganic filler, but is not limited thereto. The injection amount of the third mixed solution may be determined considering the thickness of the fourth layer 218. Thereafter, the first mixed solution 520 to the third mixed solution are simultaneously cured, so that a stamp member 213 comprising the first to fourth layers 215, 216 and 218, i.e., a transfer substrate 204, may be manufactured. The transfer substrate 204 may comprise the fourth layer 218, the first layer 215 on the fourth layer 218, and the second layer 216 on the first layer 215.

Meanwhile, as illustrated in FIG. 2, when the transfer substrate 1 is pressed for transfer to a specific block region 7 of the backplane substrate 3, the stress of the transfer substrate 1 may be transferred to the block regions 310 adjacent to the specific block region 310. In this instance, when a plurality of semiconductor light-emitting elements 5 have already been transferred among the peripheral block regions 310, there is a problem that the plurality of semiconductor light-emitting elements 5 are also warped or bent, resulting in a lighting failure due to electrical disconnection during the post-processing. In addition, when the plurality of semiconductor light-emitting elements 5 are also warped or bent, there is a problem that the already transferred semiconductor light-emitting elements are detached from the backplane substrate 3.

The fifth embodiment is an embodiment presented to solve this problem, and will be described in detail with reference to FIGS. 20 to 22.

### [Fifth embodiment]

FIG. 20 is a plan view illustrating a transfer substrate according to a fifth embodiment. FIG. 21 is a cross-sectional view illustrating a transfer substrate according to the fifth embodiment.

The fifth embodiment is similar to the first embodiment except for the recess 219. In the fifth embodiment, components having the same shape, structure, and/or function as those of the first embodiment are given the same drawing reference numerals, and detailed descriptions thereof will be omitted. The fifth embodiment may be equally applied to the second embodiment, the third embodiment, and/or the fourth embodiment.

Referring to FIGS. 20 and 21, the transfer substrate 205 according to the fifth embodiment may comprise a support member 211 and a stamp member 213. When the first layer 215 of the stamp member 213 prevents the arrangements errors of the semiconductor light-emitting elements 150 while having the function of the support member 211, the support member 211 may be omitted.

The stamp member 213 may comprise a first layer 215 and a second layer 216.

An area A1 of the first layer 215 may be greater than an area A2 of the second layer 216. The second layer 216 may have a size corresponding to the overall size of the plurality of pixels. The first layer 215 may have a first region and a second region surrounding the first region. In this instance, the first region of the first layer 215 may vertically overlap with the second layer 216. The area of the first region of the first layer 215 may be equal to the area A2 of the second layer 216. The second region of the first layer 215 may not vertically overlap with the second layer 216. That is, an upper surface of the second region of the first layer 215 is not covered by the second layer 216, and thus may be exposed to the outside.

Meanwhile, a recess 219 may be formed on the first layer 215. The recess 219 may be formed on the upper surface of the first layer 215. The recess 219 may be recessed inward from the upper surface of the first layer 215. The recess 219 may be formed on the second region of the first layer 215. The recess 219 may be formed on an upper surface of the second region of the first layer 215. The recess 219 may be formed around the first region of the first layer 215. The recess 219 may be formed along the perimeter of an outer side of the second layer 216. The recess 219 may be positioned spaced apart from the outer side of the second layer 216, but is not limited thereto.

The recess 219 formed in this manner may serve to absorb stress generated when the transfer substrate 205 is pressed. The stress transmitted from the support member 211 to the first layer 215 or the second layer 216 may be transmitted to an edge region of the first layer 215 and absorbed by the recess 219.

Although the drawing illustrates the recess 219 as having a closed loop structure along the perimeter of an outer side of the second layer 216, it may also have a pattern structure spaced apart from each other along the perimeter of an outer side of the second layer 216. The drawing illustrates the recess 219 as having an inner side that is perpendicular to the ground, but may be inclined or rounded.

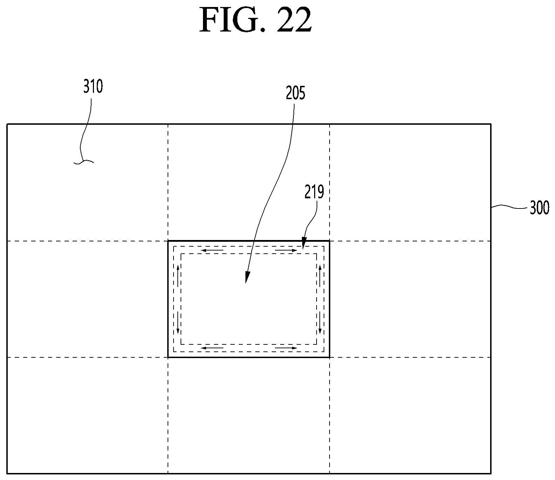

As illustrated in FIG. 22, the transfer substrate 205 according to the fifth embodiment is pressed against a specific block region 310 of the backplane substrate 300, so that a plurality of semiconductor light-emitting elements 150 on the transfer substrate 205 may be transferred onto the specific block. At this time, the stress generated on the transfer substrate 205 may be transferred to the edge region, and the stress transferred to the edge region may be absorbed by the recess 219. In this way, since the stress generated on the transfer substrate 205 is absorbed by the recess 219, the stress on the transfer substrate 205 is not transferred to the peripheral block regions 310 adjacent to the transfer substrate 205, so that the plurality of semiconductor light-emitting elements 150 that have already been transferred onto the peripheral block regions 310 may not be warped or bent. Accordingly, lighting failure due to electrical disconnection caused by a post-process can be prevented, or the semiconductor light-emitting element 150 can be prevented from being detached from the peripheral block region 310.

Meanwhile, as described above, the first mixed solution 520 and the second mixed solution 530 may be injected onto the mold 500 by an injection method. However, alternatively, the first mixed solution 520 and the second mixed solution 530 may be coated onto the mold 500 by using a coating method.

Meanwhile, the display device described above may be a display panel. That is, in the embodiment, the display device and the display panel may be understood to have the same meaning. In the embodiment, the display device in a practical sense may comprise a display panel and a controller (or processor) that may control the display panel to display an image.

The above detailed description should not be construed as limiting in all respects and should be considered illustrative. The scope of the embodiment should be determined by reasonable interpretation of the appended claims, and all changes within the equivalent range of the embodiment are included in the scope of the embodiment.

### [Industrial Applicability]

The embodiment may be adopted in the display field for displaying images or information. The embodiment may be adopted in the display field for displaying images or information using a semiconductor light-emitting element. The semiconductor light-emitting element may be a micro-level semiconductor light-emitting element or a nano-level semiconductor light-emitting element.

For example, the embodiment may be adopted in a TV, signage, a smart phone, a mobile phone, a mobile terminal, a HUD for an automobile, a backlight unit for a laptop computer, and a display device for VR, AR or MR.

## Claims

1. A transfer substrate, comprising:
a first layer; and
a second layer on the first layer,
wherein the second layer has an amount of a curing agent smaller than an amount of a curing agent of the first layer,
wherein the second layer has a tackiness greater than a tackiness of the first layer, and
wherein the second layer has a hardness smaller than a hardness of the first layer.

2. The transfer substrate of claim 1, wherein the amount of the curing agent of the first layer is 11 wt% to 13 wt%, and the amount of the curing agent of the second layer is 9 wt% to 10 wt%.

3. The transfer substrate of claim 2, wherein the second layer comprises:
a plurality of protrusions; and
a recess around each of the plurality of protrusions.

4. The transfer substrate of claim 3, wherein the plurality of protrusions each have a size corresponding to a size of at least one pixel, and
wherein the pixel comprises a plurality of subpixels corresponding to a plurality of semiconductor light-emitting elements, respectively.

5. The transfer substrate of claim 3, comprising:
a third layer in the recess.

6. The transfer substrate of claim 5, wherein the first layer to the third layer comprise the same organic material, and
wherein the third layer has an amount of the curing agent equal to or smaller than the amount of the curing agent of the first layer and greater than the amount of a curing agent of the protrusion.

7. The transfer substrate of claim 6, wherein the third layer has a tackiness equal to or greater than the tackiness of the first layer and smaller than a tackiness of the second layer, and
wherein the third layer has a hardness equal to or smaller than the hardness of the first layer and greater than a hardness of the second layer.

8. The transfer substrate of claim 5, wherein the third layer is an extension part extending from the first layer.

9. The transfer substrate of claim 5, wherein the third layer has a thickness smaller than a thickness of the protrusion.

10. The transfer substrate of claim 1, comprising a support member under the first layer, wherein the support member and the first layer comprise different organic materials.

11. The transfer substrate of claim 10, wherein the support member comprises a plastic material, and
wherein the first layer and the second layer comprise silicon materials.

12. The transfer substrate of claim 1, comprising a fourth layer under the first layer,
wherein the first layer, the second layer, and the fourth layer comprise the same organic material, and
wherein the fourth layer has an amount of a curing agent greater than the amount of the curing agent of the first layer.

13. The transfer substrate of claim 12, wherein the amount of the curing agent of the fourth layer is at least twice greater than the amount of the curing agent of the second layer.

14. The transfer substrate of claim 1, wherein the first layer has an area greater than an area of the second layer,
comprising:
a second recess along a perimeter of an outer side of the second layer in an edge region of an upper surface of the first layer.
